# EUROPÄISCHE PATENTSCHRIFT

(11) **EP 0 602 257 B1**
(45) Veröffentlichungstag und Bekanntmachung des Hinweises auf die Patenterteilung: **10.09.1997**
(21) Anmeldenummer: 92121216.3
(22) Anmeldetag: 12.12.1992
(51) Int. Cl.: H05K 1/00, H05K 3/46, H05K 1/02

(54) **Leiterplatten mit lokal erhöhter Verdrahtungsdichte und Herstellungsverfahren für solche Leiterplatten**
Printed circuits with local higher wiring density and method for manufacturing such printed circuits
Circuits imprimés avec densité de câblage localement plus élevée et méthode de fabrication de tels circuits imprimés

(43) Veröffentlichungstag der Anmeldung: 22.06.1994
(73) Patentinhaber: International Business Machines Corporation, Armonk, N.Y. 10504 (US)
(72) Erfinder: Arnold, Hans, W-7033 Herrenberg/Gültstein (DE); Lück, Peter, Dipl.-Ing., W-7250 Leonberg (DE); Mohr, Günther, Dipl.-Ing., W-7042 Aidlingen 3 (DE); Zur Nieden, Theis, Dipl.-Phys. Dr., W-7036 Schönaich (DE)
(74) Vertreter: Rach, Werner, Dr.

(56) Entgegenhaltungen:
- EP-A- 0 478 313
- EP-A- 0 498 258
- DE-A- 4 021 965
- US-A- 4 830 691

## Beschreibung

Die Erfindung betrifft Leiterplatten und ein Verfahren zum Herstellen von Leiterplatten, wie z.B. aus den Dokumenten EP-A-0 478 313 und US-A-4 830 691 bekannt ist.

Mit der dramatisch ansteigenden Integrationsdichte moderner Halbleiterbausteine wie z.B. Mikroprozessoren oder Logikchips geht zwingend eine Erhöhung der Anzahl und der Dichte der Anschlußterminals (I/O) der Chips einher. Es sind bereits Module bekannt, die Chips mit mehr als 400 Anschlüssen aufnehmen können. Allerdings ist die Grundfläche solcher Bauelemente deutlich größer als bei bisherigen Komponenten. Die Anforderungen an kritische Signalverzögerungszeiten innerhalb der Datenverarbeitungssysteme erfordern aber in steigendem Maße kleiner werdende Minimalabstände zwischen kritischen Chips.

Man kann diesen Forderungen dadurch gerecht werden, daß man mehrere Chips in aufwendigen Multi-Chip-Modulen unterbringt und damit die Abstände zwischen kritischen Chips extrem klein macht.

Idealer wäre es allerdings, die Chips direkt auf die Leiterplatte aufzulöten (Direct Chip Attach, DCA), da hierbei eine gesamte Packaging- Ebene wegfallen würde und folglich neben verringerten Signalverzögerungen erhebliche Kosteneinsparungen erzielbar wären. In diesem Fall müßten allerdings die Leiterzugbreiten und -abstände sowie die entsprechenden Durchgangslöcher in Chipnähe erheblich kleiner sein als dies mit konventioneller Leiterplattentechnik machbar ist.

Eine ganze Reihe von Vorschlägen sind zur Lösung dieses Problems gemacht worden, so zum Beispiel der sogenannte SLC (Surface laminar circuit)-Prozess, bei dem über zwei Dünnfilmlagen auf der Oberfläche einer konventionellen Leiterplatte Chips direkt auf die Kontakte der Platine aufgelötet werden können. Dieser Fertigungsprozess ist relativ komplex und erfordert aufwendige Registrier- und Glättungsverfahren.

Aufgabe der vorliegenden Erfindung ist es somit, ein kostengünstig durchführbares Verfahren zum Herstellen von Leiterplatten, die über eine für das direkte Aufbringen von Chips ausreichende Verdrahtungskapazität verfügen, zur Verfügung zu stellen.

Diese Aufgabe wird erfindungsgemäß durch ein Verfahren mit folgenden Verfahrensschritten gelöst:
a.) Herstellen einer Leiterplatte mit Innenlagen und äußeren Leiterzügen, deren Verdrahtungsdichte der des ersten Bereiches entspricht;
b.) Aufbringen eines Dielektrikums auf einem Teilbereich der Oberfläche der Leiterplatte;
c.) Beschichten der gesamten Leiterplatte mit einem ersten Photoresist, Belichten des Photoresists und nach dem Entwickeln Entfernen des Photoresists von dem Teilbereich;
d.) Einbringen von Bohrungen durch das Dielektrikum zu den Leiterzügen in dem Teilbereich;
e.) Aufbringen einer Metallschicht auf die gesamte Leiterplatte, insbesondere auf den Teilbereich;
f.) Beschichten der gesamten Leiterplatte, insbesondere des Teilbereiches, mit einem zweiten Photoresist, musterförmiges Belichten des Photoresists, insbesondere im Teilbereich 5, und Entwickeln des Photoresists;
g.) Entfernen der Metallschicht, wo diese nicht von Photoresist bedeckt ist, und Entfernen des ersten und des zweiten Photoresists.

In den Unteransprüchen 2 bis 7 sind weitere vorteilhafte Ausführungen des erfindungsgemäßen Verfahrens dargestellt.

Das erfindungsgemäße Verfahren ermöglicht es, lediglich in den Teilbereichen der Leiterplatte, in denen Halbleiterbausteine direkt aufgebracht werden, d.h., in Bereichen mit sehr hohen Anforderungen bezüglich der I/O- Dichte, eine sehr hohe Verdrahtungsdichte zur Verfügung zu stellen. Damit müssen die kritischen Prozeßschritte nur an wenigen Positionen der Leiterplatte durchgeführt werden.

Desweiteren können auf diese Weise Schwierigkeiten mit Planaritätsanforderungen im DCA-Chip-Bereich vermieden werden.

Es können somit Leiterplatten hergestellt werden, die einen ersten Bereich mit einer ersten Verdrahtungsdichte und einen zweiten Bereich mit einer zweiten Verdrahtungsdichte aufweisen, wobei die erste Verdrahtungsdichte mehr als ca. 5 cm/cm², vorzugsweise 10 cm/cm², und die zweite Verdrahtungsdichte mehr als 20 cm/cm², vorzugsweise 40 cm/cm² beträgt.

So lassen sich bspw. kostengünstig PIH (Pin-in-hole)- bzw. SMT (surface mount technology)- Komponenten und Chips gleichzeitig auf einer Karte plazieren.

Durch eine geeignete automatisierte Registrierungsroutine kann ausserdem eine sehr genaue Registrierung bzw. Positionierung während der entsprechenden Verfahrensschritte erreicht werden.

Im folgenden wird das erfindungsgemäße Verfahren anhand der Zeichnungen näher erläutert.

Es zeigt
- Fig. 1: eine schematische Darstellung der erfindungsgemäßen Verfahrensschritte,
- Fig. 2: ein automatisiertes Belichtungs- bzw. Registrierungssystem zur Durchführung des erfindungsgemäßen Verfahrens,
- Fig. 3: den schematischen Ablauf einer Belichtungssequenz während des erfindungsgemäßen fahrens,
- Fig. 4: einen rotierenden Belichtungskopf zur Durchführung des erfindungsgemäßen Verfahrens, und
- Fig. 5: den schematischen Aufbau einer Leiterplatte, auf der PIH- bzw. SMT-Komponenten und Chips gleichzeitig montiert sind.

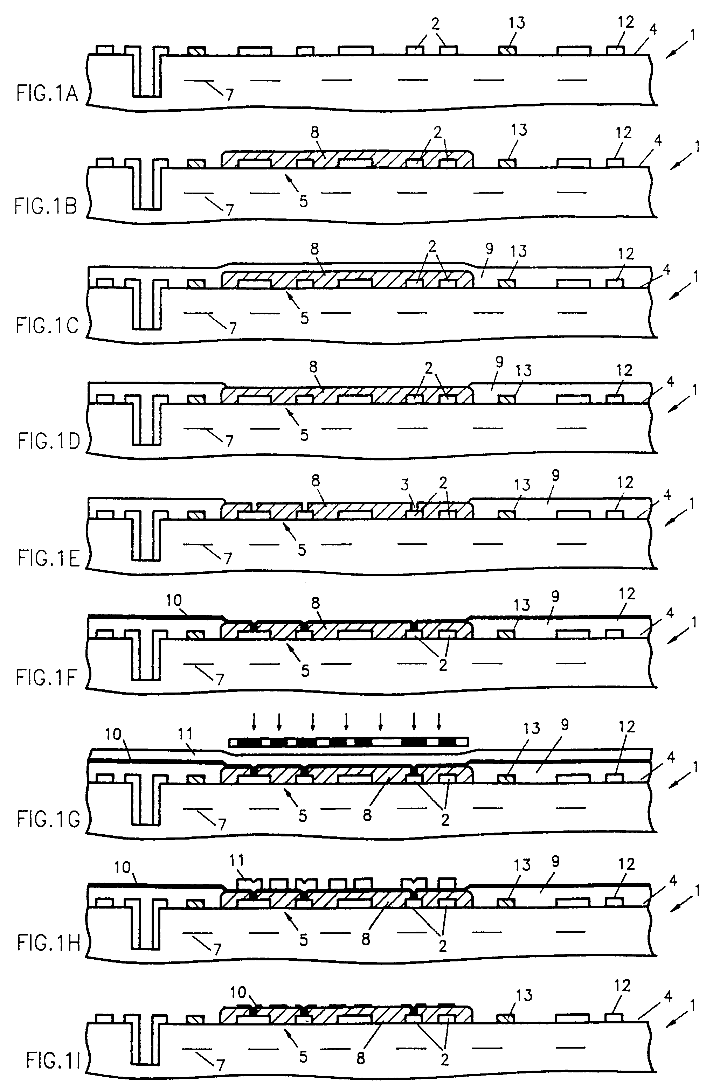

Wie aus Fig. 1 ersichtlich, wird zunächst die Leiterplatte 1 mit den Innenlagen 7 einschließlich beider strukturierter Aussenlagen, d.h., einschliesslich der aus einem leitenden Material bestehenden Leiterzüge 2 fertiggestellt. Hierzu werden in der Leiterplattentechnologie allgemein bekannte Herstellungsverfahren angewandt. Die Verdrahtungsdichte der Leiterzüge 2 entspricht dabei der eines ersten Bereichs 4, d.h., sie beträgt mehr als ca. 5 cm/cm², vorzugsweise ca. 10 cm/cm² (Fig. 1A).

Anschließend wird an den für den späteren DCA-Prozess vorgesehenen Positionen, d.h., in einem Teilbereich 5 der Leiterplatte 1 eine dünne Schicht eines geeigneten Dielektrikums 8 auf der Oberfläche der Leiterplatte aufgebracht. Dies kann z.B. mittels einer Vakuum-Laminierpresse geschehen. Als Dielektrikum kann jedes Polymermaterial mit einer Dielektrizitätskonstanten im Bereich von etwa 2,5 bis etwa 3,5 verwendet werden. Vorzugsweise wird jedoch reines oder verstärktes Polyimid verwendet. Die Dicke der Folie wird je nach der elektrischen Konfiguration (Impedanz, Leiterzugabstand) ausgewählt, sie beträgt vorzugsweise 25-50 µm (Fig. 1B).

Im nächsten Schritt wird dann die gesamte Oberfläche der Leiterplatte 1 mit einem ersten Photoresist 9 beschichtet, registriert, belichtet und der vorher laminierte Teilbereich 5 durch Entwickeln des Photoresist freigelegt (Fig. 1C, 1D).

Anschließend werden Bohrungen 3 zu den Leiterzügen 2 durch das Dielektrikum 8 im Teilbereich 5 eingebracht. Diese Bohrungen können durch bekannte Verfahren (Bohren, Aetzen) hergestellt werden. Vorzugsweise wird jedoch mit einem geeigneten Laser-Verfahren, bspw. mit einem Excimer-Laser, gearbeitet, das es erlaubt, Verbindungslöcher (Sacklöcher) mit sehr kleinem Durchmesser (< 100 µm) einzubringen (Fig. 1E).

Selbstverständlich können mit Hilfe des erfindungsgemäßen Verfahrens nicht nur Sacklöcher, sondern beispielsweise auch Durchgangslöcher hergestellt werden.

Nach einer geeigneten Vorbehandlung (wie beispielsweise das Aufbringen eines Pd-seed layers) wird dann galvanisch eine relativ dünne Metallschicht (bevorzugt < 16 µm), vorzugsweise Kupfer, ganzflächig auf die Leiterplatte 1, insbesondere jedoch auf den Teilbereich 5, d.h., an den für den späteren DCA-Prozess vorgesehenen Positionen, aufgebracht (Fig. 1F). Das Aufbringen dieser Kupferschicht kann beispielsweise über ein Direct-Plating-Verfahren erfolgen.

Dann wird die gesamte Leiterplatte 1, insbesondere aber der Teilbereich 5 mit einem zweiten Photoresist 11 beschichtet, wobei es sich bei dem Resist bevorzugt um eine auflaminierte Photolackfolie handelt, aber auch ein Flüssigresist angewandt werden kann. Der aufgebrachte Photoresist wird musterförmig, beispielsweise mit Hilfe einer Photomaske, belichtet, wobei diese Belichtung wiederum insbesondere in dem Teilbereich 5, und, wie weiter unten beschrieben, in zwei Schritten, erfolgt, und anschließend wird der Resist entwickelt (Fig. 1G, 1H). Die Belichtung der DCA-Positionen erfolgt für jede dieser Positionen einzeln, dabei wird vorzugsweise die in der Halbleitertechnologie seit langem bekannte Stepper-Technik angewendet.

Im letzten Schritt wird dann die Metallschicht 10 an den Stellen, wo sie nicht von Photoresist 11 bedeckt ist, entfernt, was z.B. durch Aetzen erreicht werden kann. Schließlich werden beide Photoresistlagen 9 und 11 entfernt. Die Leiterzüge im Teilbereich 5 sind jetzt strukturiert und mit der darunter liegenden Kupferebene verbunden. Die Verdrahtungsdichte in dem Teilbereich 5 ist dabei etwa um den Faktor 4 höher als in dem ersten Bereich 4, d.h., sie beträgt mehr als ca. 20 cm/cm², bevorzugt ca. 40 cm/cm² (Fig. 1I).

Die nachfolgenden Prozesschritte, wie z.B. das Aufbringen einer Lötstopmaske, entsprechen dem konventionellen Ablauf bei der Leiterplatten-Herstellung.

Für die Registrierung der in Schritt c.) zu belichtenden Bereiche sind im Randbereich der Leiterplatte 1 globale Registrationsmarken 12, beispielsweise in Form von runden oder rechteckigen Marken, aufgebracht. Eine mechanische Registrierung reicht allerdings in vielen Fällen nicht mehr aus. Die Bereiche hoher Verdrahtungsdichte und somit enger Toleranzen erfordern für die Registrierung optisch aufzunehmende lokale Registrationsmarken 13, da Registriergenauigkeiten im Bereich weniger Mikrometer gefordert sind. Die Registrierung über diese Marken 13 erfolgt daher vorzugsweise mittels optischer Kameraregistration über eine vergrößernde Optik.

Die erhöhte Verdrahtungsdichte in dem Teilbereich 5 erfordert bei der Registrierung eine genaue Ausrichtung zum Glassmaster und gleichzeitig höchste Genauigkeit bei dessen Herstellung. Die Ausbeute des photolithographischen Prozesses hängt wesentlich von der Registrierung des Produkts (Core/Composite) zum Glassmaster und der Größe des Produkts ab. Über das erfindungsgemäße Verfahren wird durch die Registrierung über die Registrationsmarken 12 mittels optischer Kameraregistration sowie durch die Registrierung über die lokalen Registrationsmarken 13 mittels Projektion durch eine vergrößernde Optik die Notwendigkeit für hochgenaue Glassmaster drastisch reduziert. Gleichzeitig kann durch eine automatisierte Registrierungs-/Belichtungsroutine die Positionierung/Registrierung Registrierung der Produkte wesentlich vereinfacht werden.

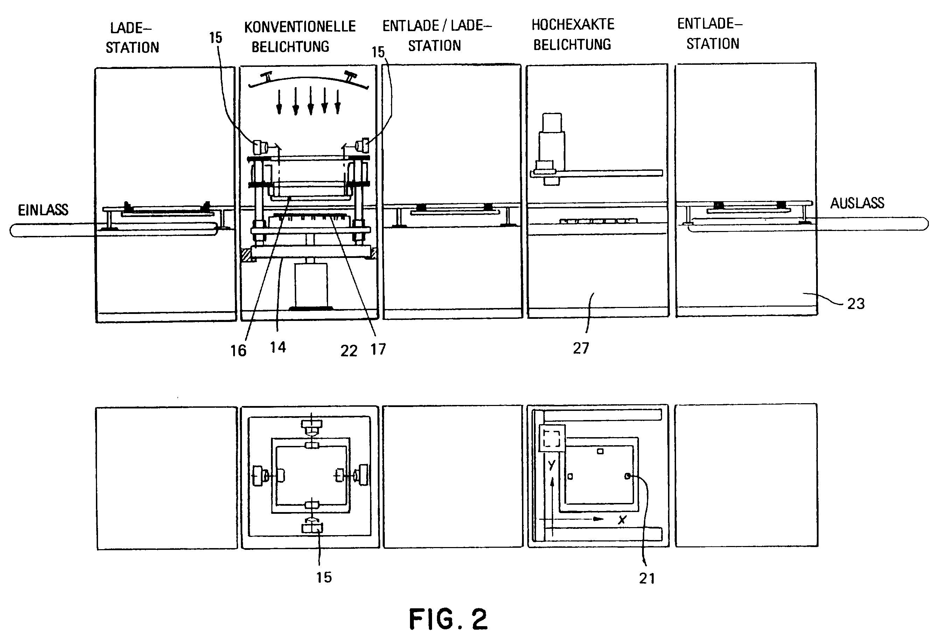

Diese schrittweise Routine erlaubt es, die Bereiche mit geringeren Toleranzanforderungen und die "fine-line"-Bereiche für die DCA-Positionen unabhängig voneinander zu belichten. Die optische Registrierung benutzt optische Merkmale, die auf dem Glassmaster und/oder dem Produkt vorhanden sind. Fig. 2 zeigt ein solches automatisiertes Registrierungs-/Belichtungssystem.

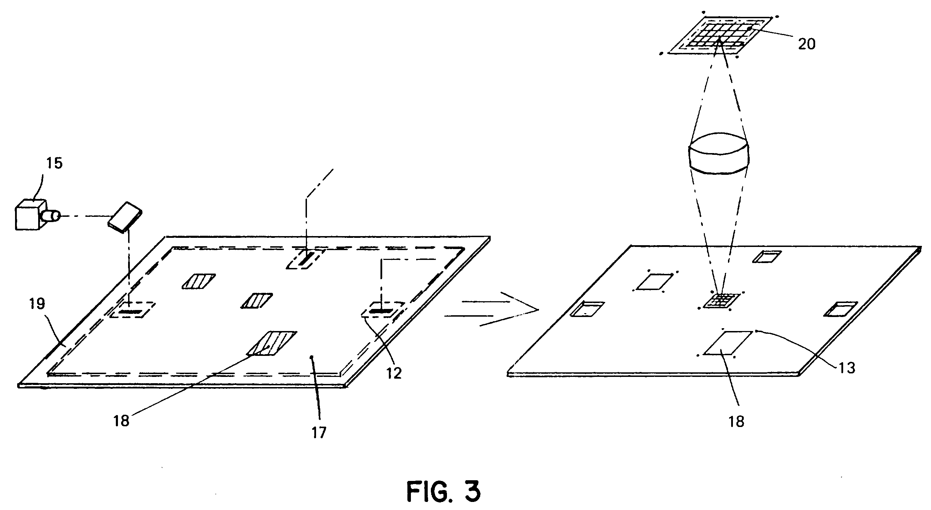

Glassmaster 19 und Produkt 17 werden beide mittels einer Ladetransporteinrichtung zum Belichtungstisch 14 überführt. Zunächst wird das Glassmaster zu einem Rahmen auf dem Belichtungstisch geführt, mit Hilfe eines Kamerasystems 15 positioniert und in dieser Position entweder mechanisch oder durch Vakuum festgehalten. Dann wird das Produkt in seine Position gebracht und automatisch in Bezug auf das Glassmaster registriert. In einer ersten Belichtungseinheit 22 wird dann das Produkt durch eine Maske 16 belichtet. Die DCA-Positionen werden dabei zunächst durch sogenannte "Black Layer" 18 auf dem Glassmaster abgedeckt, um eine Belichtung dieser Bereiche im ersten Schritt zu verhindern (Fig. 3).

Für den zweiten Belichtungsvorgang wird das Produkt durch eine zweite Aufnahme- und Positioniereinrichtung in die zweite Belichtungseinheit 27 des Geräts überführt. Diese Belichtungseinheit, vorzugsweise ein "Projection Printing Device" mit rotierendem Kopf, wird nun aktiviert, die DCA-Positionen werden mittels einer Kamera aufgesucht und mit Hilfe von lokalen Positionsmarkierungen 13 in der Nähe der Chip-Positionen registriert. Da diese Registrierungsmarken zur selben Zeit auf das Produkt gebracht wurden wie die äußeren Leiterzugbahnen, stehen sie in enger Relation zum Leiterzugmuster (Fig. 3).

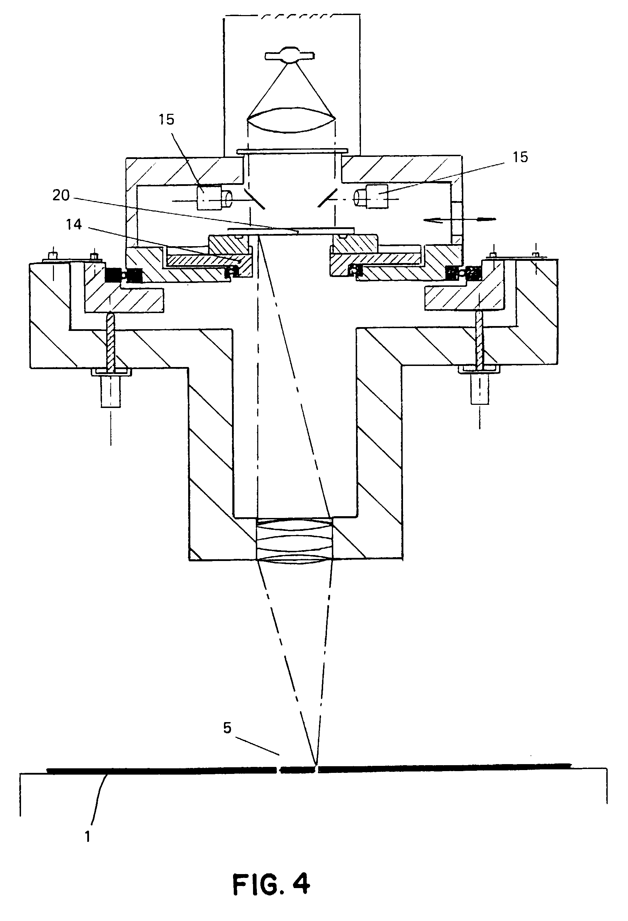

Durch den rotierenden Kopf des "Projection Printing Device" (Fig. 4) wird eine Anpassung verschiedenster Masken an das Layout der Leiterplatte 1 ermöglicht. Nachdem das Produkt in der entsprechenden Position festliegt, werden die DCA- Positionen durch eine "Chip-Site"- Maske 20 belichtet. Diese Schritte werden so oft wiederholt, bis alle DCA-Positionen belichtet sind. Anschließend wird das Produkt einer Einrichtung zugeführt, in der die Entwicklungs-, Ätz- und Entfernungsschritte durchgeführt werden. Bei der Belichtung bewegt sich der Belichtungskopf in der x-y-Ebene, um den gesamten aktiven Bereich des Produkts abzudecken.

Die Feinabstimmung der hochgenauen Registration für x, y und den Winkel Theta wird im oberen Teil des Belichtungskopfes durchgeführt. Dies kann mit einem positionierer geschehen, wodurch eine einfache weise des Kopfes gewährleistet ist. Die positionierung des rotierenden Kopfes zur nächsten DCA-Position kann durch einen PC mit angeschlossenem linearen x-y- Steppermotor erreicht werden.

Anschließend wird dann das Produkt der Ausgabestation 23 der Belichtungseinrichtung zugeführt und für die restlichen Prozesschritte ausgegeben.

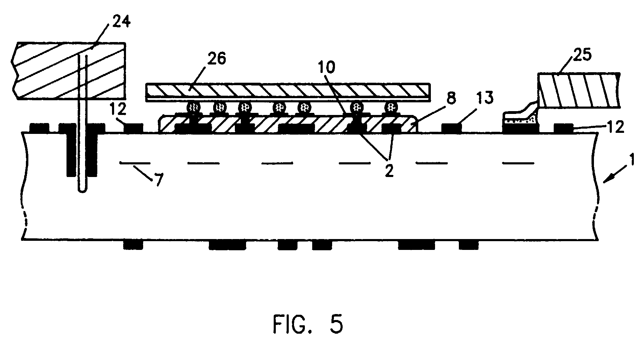

Durch das erfindungsgemäße Verfahren ist es möglich, lediglich in Teilbereichen einer Leiterplatte, in denen Halbleiterbausteine direkt aufgebracht werden, d.h., in Bereichen mit sehr hohen Anforderungen bezüglich der I/O- Dichte, eine sehr hohe Verdrahtungsdichte zur Verfügung zu stellen. Es können somit Leiterplatten mit lokal erhöhter Verdrahtungsdichte hergestellt werden, die es u.a. auch ermöglichen, kostengünstig PIH- (24) bzw. SMT-Komponenten (25) und Chips (26) gleichzeitig auf einer Karte zu plazieren (Fig. 5).

## Patentansprüche

1. Verfahren zum Herstellen von Leiterplatten, gekennzeichnet durch folgende Verfahrensschritte:
a.) Herstellen einer Leiterplatte (1) mit Innenlagen (7) und äußeren Leiterzügen (2), deren Verdrahtungsdichte der des ersten Bereiches (4) entspricht;
b.) Aufbringen eines Dielektrikums (8) auf einem Teilbereich (5) der Oberfläche der Leiterplatte (1);
c.) Beschichten der gesamten Leiterplatte mit einem ersten Photoresist (9), Belichten des Photoresists und nach dem Entwickeln Entfernen des Photoresists von dem Teilbereich (5);
d.) Einbringen von Bohrungen (3) durch das Dielektrikum (8) zu den Leiterzügen (2) in dem Teilbereich (5);
e.) Aufbringen einer Metallschicht (10) auf die gesamte Leiterplatte, insbesondere auf den Teilbereich (5);
f.) Beschichten der gesamten Leiterplatte, insbesondere des Teilbereiches (5), mit einem zweiten Photoresist 11, musterförmiges Belichten des Photoresists, insbesondere im Teilbereich (5), und Entwickeln des Photoresists;
g.) Entfernen der Metallschicht (10), wo diese nicht von Photoresist (11) bedeckt ist, und Entfernen des ersten und des zweiten Photoresists (9) und (11).

2. Verfahren gemäß Anspruch 1, dadurch gekennzeichnet, daß das Dielektrikum (8) in Form einer auf die Leiterplatte (1) auflaminierten Folie aufgebracht wird.

3. Verfahren gemäß Anspruch 1 oder 2, dadurch gekennzeichnet, daß die Metallschicht (10) eine, vorzugsweise durch galvanische Prozesse aufgebrachte, Kupferschicht ist.

4. Verfahren zum Herstellen von Leiterplatten gemäß einem oder mehreren der Ansprüche 1-3, dadurch gekennzeichnet, daß das Dielektrikum (8) ein Polymermaterial, vorzugsweise Polyimid, ist.

5. Verfahren gemäß einem oder mehreren der Ansprüche 1 bis 4, dadurch gekennzeichnet, daß für die Registrierung der in Schritt c.) zu belichtenden Bereiche globale Registrationsmarken (12) auf der Leiterplatte (1) vorhanden sind, die in Schritt a.) generiert wurden.

6. Verfahren gemäß Anspruch 5, dadurch gekennzeichnet, daß in den Schritten d.) bis g.), soweit nur der Teilbereich (5) bearbeitet wird, die Registration über lokale Registrationsmarken (13) erfolgt, die in Schritt a.) erzeugt wurden.

7. Verfahren gemäß Anspruch 5 oder 6, dadurch gekennzeichnet, daß die Registration über die auf der Leiterplatte vorhandenen Registrationsmarken (12) mittels optischer Kameraregistration und die Registration über die lokalen Registrationsmarken (13) mittels Projektion durch eine vergrößernde Optik erfolgt.

## Claims

1. Process for manufacturing printed circuit boards, characterized by the following steps:
a) providing a printed circuit board (1) having inner layers (7) and outer conducting lines (2), wherein the wiring density of said conducting lines (2) corresponds to that of said first region (4);
b) applying a dielectric (8) on said sub-region (5) of the surface of said printed circuit board (1);
c) coating of the whole printed circuit board with a first photoresist (9), exposing and removing said photoresist from said sub-region (5) after developing said photoresist;
d) placing holes (3) through said dielectric (8) to the conducting lines (2) in said sub-region (5);
e) depositing a metal layer (10) onto the whole printed circuit board, especially onto said sub-region (5);
f) coating the whole printed circuit board, especially said sub-region (5), with a second photoresist (11), imagewise exposing said photoresist, especially in the said sub-region (5), and developing said photoresist;
g) removing said metal layer (10), where it is not covered by said photoresist (11), and removing said first and said second photoresist.

2. Method as revealed in claim 1, characterized in that said dielectric (8) is applied in the form of a film laminated onto said printed circuit board (1).

3. Method as revealed in claims 1 or 2, characterized in that said metal layer (10) is a copper layer, preferably applied by electro-depositional processes.

4. Method for the manufacture of printed circuit boards as revealed in one or more of claims 1 to 3, characterized in that said dielectric (8) is a polymer material, preferably polyimide.

5. Method as revealed in one or more of claims 1 to 4, characterized in that global registration marks (12), generated in step a), are applied to the printed circuit board (1) for the purposes of registering the regions to be exposed in step c).

6. Method as revealed in claim 5, characterized in that registration in steps d) to g), in so far as only the sub-region is being exposed, is carried out using local registration marks (13) which were generated in step a).

7. Method as revealed in claim 5 or claim 6, characterized in that registration using said registration marks (12) provided on the printed circuit board is achieved by optical camera registration and that registration using said local registration marks (13) is achieved by means of projection through an enlarging optical system.

## Revendications

1. Procédé de fabrication de plaquettes à circuit imprimé, caractérisé par les étapes de procédé ci-après:
a.) fabrication d'une plaquette à circuit imprimé (1) présentant des couches intérieures (7) et des tracés conducteurs (9) extérieurs, dont la densité de câblage correspond à celle d'une deuxième zone (4);
b.) application d'un diélectrique (8) sur une zone partielle (5) de la surface de la plaquette à circuit imprimé (1);
c.) revêtement de l'ensemble de la plaquette à circuit imprimé par une première photoréserve (9), illumination de la photoréserve et, après développement, enlèvement de la photoréserve de la zone partielle (5);
d.) aménagement de perçages (3) à travers le diélectrique (8), menant au tracé conducteur (7) se trouvant dans la zone partielle (5);
e.) application d'une couche métallique (10) sur la totalité de la plaque à circuit imprimé, en particulier sur la zone partielle (5);
f.) revêtement de l'ensemble de la plaque à circuit imprimé, en particulier sur la zone partielle (5) avec une deuxième photoréserve (11), illumination selon un motif de la photoréserve, en particulier dans la zone partielle (5) et développement de la photoréserve;
g.) enlèvement de la couche métallique (10), là où celle-ci n'est pas recouverte par la photoréserve (11), et enlèvement de la première et de la deuxième photoréserve (9) et (11).

2. Procédé selon la revendication 1, caractérisé en ce que le diélectrique (8) est appliqué sous la forme d'une feuille rapportée à l'occasion d'un laminage, sur la plaquette à circuit imprimé (1).

3. Procédé selon la revendication 1 ou 2, caractérisé en ce que la couche métallique (10) est une couche de cuivre, de préférence appliquée au moyen de processus galvaniques.

4. Procédé de fabrication de plaquettes à circuit imprimé selon l'une ou plusieurs des revendications 1 à 3, caractérisé en ce que le diélectrique (8) est un matériau polymère, de préférence du polyimide.

5. Procédé selon l'une ou plusieurs des revendications 1 à 4, caractérisé en ce que des marques de repérage (12) globales, pour le repérage des zones à illuminer à l'étape c.), sont réalisées sur la plaquette à circuit imprimé (1) ayant été générée à l'étape a.).

6. Procédé selon la revendication 5, caractérisé en ce que dans la mesure où seule la zone partielle (5) est usinée, aux étapes d.) à g.), le repérage s'effectue par l'intermédiaire de marques de repérage (13) locales, ayant été générées à l'étape a.)

7. Procédé selon la revendication 5 ou 6, caractérisé en ce que le repérage s'effectue par l'intermédiaire des marques de repérage (12) existant sur la plaquette à circuit imprimé, au moyen d'un repérage optique fait par caméra, et le repérage s'effectuant par l'intermédiaire des marques de repérage (13) locales, par une projection au moyen d'une optique grossissante.
